Europäisches Patentamt

European Patent Office

Office européen des brevets

(19)

(11) Publication number: **0 227 292 B1**

# EUROPEAN PATENT SPECIFICATION

(12)

(45) Date of publication of patent specification: **25.09.91**  (51) Int. Cl.⁵: **H05K 13/00, B65D 85/42**

(21) Application number: **86308938.9**

(22) Date of filing: **17.11.86**

(54) Packaging of electrical components.

(30) Priority: **28.11.85 GB 8529355**

(43) Date of publication of application:
**01.07.87 Bulletin 87/27**

(45) Publication of the grant of the patent:
**25.09.91 Bulletin 91/39**

(84) Designated Contracting States:
**AT BE CH DE ES FR GB IT LI LU NL SE**

(56) References cited:
**EP-A- 0 102 185**
**EP-A- 0 130 489**
**DE-U- 8 436 204**
**GB-A- 2 081 226**
**US-A- 4 327 832**

(73) Proprietor: **Yen Wei Hsiung**
**Block 103, Tao Ching Road**
**04-30 Singapore 2261(SG)**

(72) Inventor: **Yen Wei Hsiung**
**Block 103, Tao Ching Road**
**04-30 Singapore 2261(SG)**

(74) Representative: **Hall, Graeme Keith et al**
**Frank B. Dehn & Co. Imperial House 15-19**
**Kingsway**
**London WC2B 6UZ(GB)**

## Description

This invention relates to the packaging of electrical components, particularly of the type having terminals in a so-called "dual-in-line" configuration, that is two laterally spaced rows of terminals protruding in substantially the same direction so that the component is substantially U-shaped in transverse cross-section, the rows of terminals forming the legs of the U and the body of the component forming the central portion thereof. Such an electrical component is that hereinafter referred to as being "of the kind described".

Some components of this kind, for example metal-oxide semi-conductor (MOS) integrated circuits, are highly susceptible to static electrical charges and must be packed in anti-static or conducting containers so as to prevent the application of a static charge to one of the terminals of the component which could cause an internal electrical breakdown.

It is known from GB 1593760 to provide such a container in the form of a tubular member of uniform closed inverted U-shaped cross section formed of plastics material, said cross section consisting of a base wall portion adapted to support the bodies of a row of said components therein, a flanking portion on each side of the said base portion adapted to receive respective rows of said terminals, and a top portion adapted to overlie said component bodies and joining the respective flanking portions, said base and flanking portions being electrically conductive and said top portion being transparent.

This container is generally effective in protecting components packed therein, but it is relatively expensive since it is made mostly of conducting material, excepting only the transparent top. GB-A-2081226 discloses a container for housing components of the kind described in the container that has a transparent upper half for inspection, and a conductive lower half for receiving the terminals. However, components can still be damaged if the tube is inverted in use, and inspection of the rows of terminals is difficult.

Accordingly the present invention is characterised in that said tubular member comprises a plurality of spaced electrically conductive portions which are contactable by a said component when housed therein, the remainder of the the tubular member being non-contactable by a said component when housed therein and being substantially transparent, said conductive portions being electrically interconnected.

Clearly such an arrangement substantially minimises the amount of electrically conductive material in the container, thus substantially reducing its cost and at the same time substantially maximising its transparency.

In a preferred form of the invention the said electrical conductivity is provided substantially in only three portions of the said container extending lengthwise thereof, the conductive portions comprising the base wall of the said hollow central portion so as to underlie the said body of the or each component, and two opposed inwardly projecting portions of the container arranged to extend along the opposite sides of the said component(s) and to engage the latter upon upward or lateral displacement thereof, whereby to prevent the component(s) from coming into contact with any non-conductive portions of the container.

As stated above, the said conductive portions are substantially the only parts of the said tubular member which are contactable by the or each component, but means are also provided to electrically interconnect the aforementioned conducting portions, so as to provide for uniform conductivity and thereby avoid differences in voltages which might cause short-circuiting of the components.

Preferably the electrical interconnections are provided at one or both ends of the container, however it will be appreciated that there are other possible arrangements. While an electrical connection at each end of the tube is preferred, it is possible to provide only a single connection at any point along the tube. Indeed connections between different adjacent pairs of conductive portions could be provided at different positions.

The container may be formed from suitable plastics material, preferably PVC. The electrically conductive portions thereof may be formed in any suitable manner, but it is preferred to form them by incorporating carbon particles in the material forming the container. The transparent parts of the container may be made antistatic if desired, while still remaining substantially transparent, for example by providing them with a transparent anti-static coating.

Additionally the container may be provided with a plurality of upstanding conducting ribs on the external surface of the tubular member, arranged so that when two such containers are juxtaposed side by side it is not possible for any non-conductive portions of the containers to contact each other. This reduces the amount of static that is generated in a stack of such containers since the contact between two containers is either between two conductive portions or a conductive and a non-conductive portion. Preferably these ribs are provided on all the outwardly projecting corners of the tubular member.

Preferably a pair of end plugs are provided, formed of plastics material, which seal the ends of the tubular member.

Some embodiments of the invention will now be described by way of example and with reference to the accompanying drawings in which:-

Figure 1 is a transverse cross-sectional view of a first embodiment of a container according to the invention, containing an electrical component of the kind described;

Figure 2 is a view similar to Figure 1 showing a second embodiment;

Figure 3 is a perspective view of the container of Fig. 1;

Figure 4 is a cross-sectional view of the containers of Figures 1 and 2 in use,

Figure 5 is a view of modified forms of the embodiments of Figures 1 and 2; and

Figure 6 is a view of a stack of the containers of Fig 5(a).

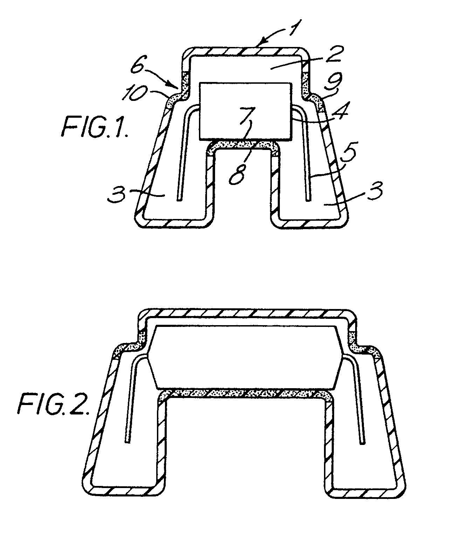

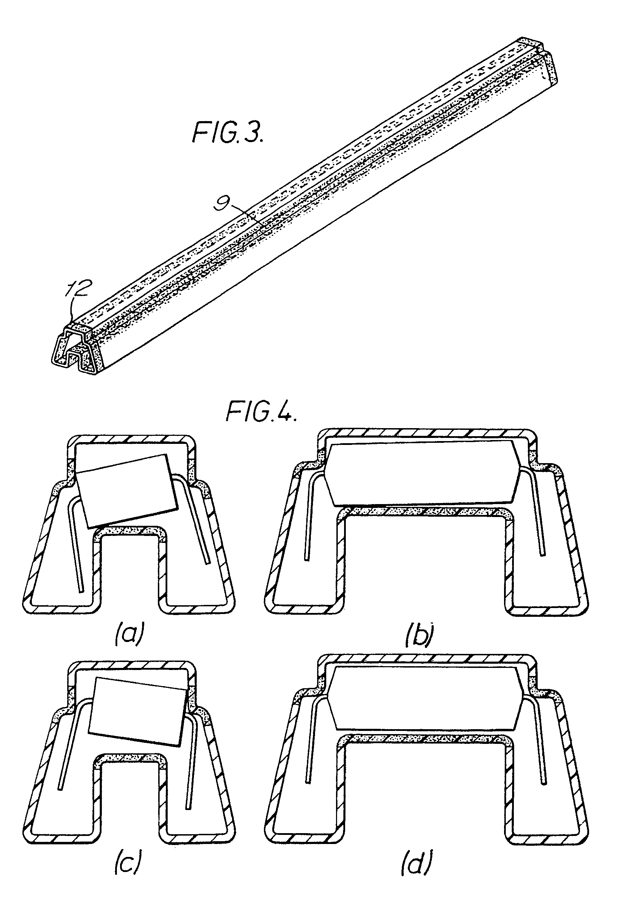

Referring first to Figures 1 and 3, there is shown a container 1 having a closed substantially U-shaped transverse cross-section. This cross-section includes a hollow central portion 2, and a hollow flanking portion 3 on each side of the central portion. These hollow portions are arranged so that, in use, the body portion 4 of an electrical component of the kind described is held within the central portion 2 and its rows of terminals 5 are received within the respective flanking portions 3.

The width of the central portion 2 is only slightly greater than the width of the body portion of an electrical component to be housed in the container. In addition two opposed shoulders 6 are provided in the outside walls of the tubular member 1 at the junctions between the central portion and the flanking portions. The shape of each such shoulder corresponds approximately to the shape of the terminals 5 where they join the body portion 4 of the electrical component. As a consequence the possible movement of the electrical component is restricted and the component can only contact the tubular member 1 in three regions, namely in the vicinity of the shoulders 6 and the portion 7 of the tubular member defining the base wall or floor of the central hollow portion 2. This latter part of the tubular member underlies and supports the body 4 of an electrical component housed within the tubular member.

Thus, in order to protect an electrical component from a static discharge when it contacts the tubular member, it is only necessary that the aforementioned regions of possible contact should be electrically conductive. These possible places of contact are shown in the drawings as the darkly shaded parts. Thus the tubular member has three strips 8, 9 and 10 of conductive material extending along its length, which are formed by incorporating carbon particles in the plastics material.

The embodiment of Figure 2 is substantially the same as that of Figure 1 save that it is much wider in order to accommodate a wider electrical component.

The tubular member is also be provided with additional electrically conductive portions 12 (Fig. 3) at one or both ends which electrically interconnect the three longitudinally extending strips 8, 9 and 10. In the absence of such a provision it would be possible for two of the conductive strips to be at different potentials, and if an electrical component were to contact such two strips simultaneously a potential difference would be applied across the component and it could be damaged.

The tubular member is formed from a plastics material such as PVC and is generally transparent except for the electrically conductive portions thereof.

There may also be provided two end plugs (not shown) made of a suitable plastics material and each having a projecting portion shaped to fit within an end of the tubular member and a rim which abuts the end of the tubular member. It would of course be possible for the aforementioned means electrically interconnecting the said conductive portions to be provided on one or both of the end plugs.

As is shown in Fig. 4 the cross-sectional shape of the tubular member is such that an electrical component of the kind described can only contact the walls of the tubular member at three regions, which are rendered conductive by the addition of conducting material. This enables the amount of conducting material needed to be greatly reduced, and accordingly it is possible to manufacture the tubular member out of predominantly transparent material allowing the observation of components contained within the tubular member. Figs. 4(a) 4(c) show a component held within the container of Fig. 1 while Figs. 4(b) and 4(d) show a component held within the container of Fig. 2. As can be seen from Fig. 4 no matter how the component moves it only touches the base portion and the opposed shoulders of the tubular member.

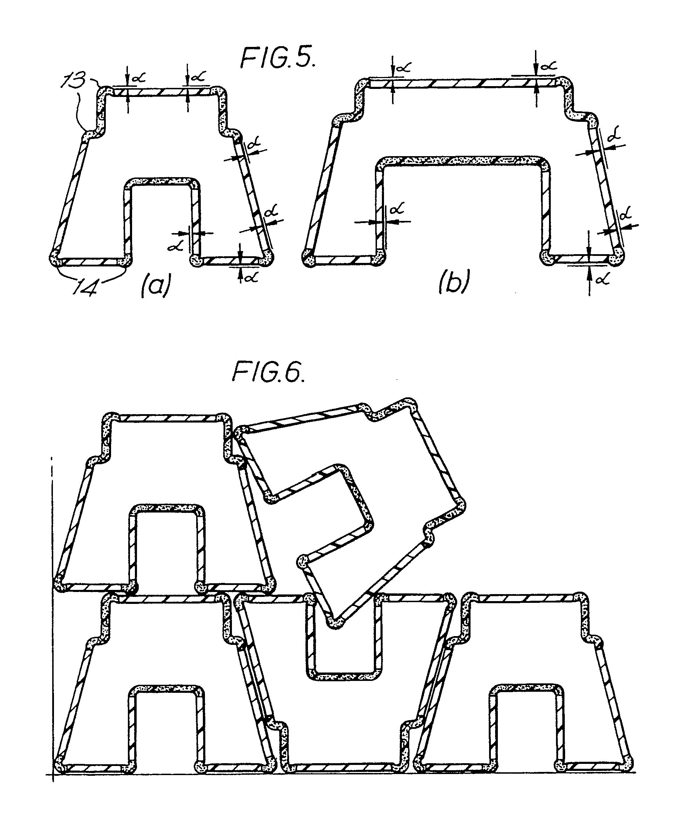

One of the major causes of static charge being present on such containers is friction occuring between the non-conducting portions of two such containers when they rub against each other. It is therefore desirable to prevent the non-conducting portions of one container from contacting the non-conducting portions of another when they are juxtaposed side by side. Figs. 5(a) and 5(b) show modified forms of the embodiments of Figs 1 and 2 respectively, which meet this requirement.

In these modified containers bulbous ribs of electrically conductive material extend longitudinally along the outwardly directed corners 13 of the shoulder portion and the upper part of the central portion, and the outwardly directed corners 14 at the base of the flanking portions. As shown in Fig 5 these conductive ribs extend a distance $\alpha$ above

the principal surfaces of the container. The effect of these ribs is to prevent the non-conducting portions of two containers from contacting one another when the containers are stacked. This effect is shown in Fig. 6, which shows a stack of such containers, where it will be seen that all contacts between adjacent containers are either between conductive material and conductive material, or between conductive material and non-conductive material.

## Claims

1. A container for loosely housing at least one electrical component having a body portion (4) and two rows of terminals (5) extending from opposed sides of said body portion (4), said container comprising an elongate tubular member (1) of closed substantially inverted U-shaped transverse cross-section, said cross-section including a hollow central portion (2) for receiving the said body portion (4) of the or each said component, and two hollow flanking portions (3) one on each side of said central portion (2) for receiving the said rows of terminals (5), the container being partly of electrically conductive material and partly of transparent material, characterised in that said tubular member (1) comprises a plurality of spaced electrically conductive portions (8,9,10) which are contactable by a said component when housed therein, the remainder of the the tubular member (1) being non-contactable by a said component when housed therein and being substantially transparent, said conductive portions (8,9,10) being electrically interconnected.

2. A container according to claim 1 wherein said conductive portions (8,9,10) extend lengthwise of the container and comprise the base wall (8) of said hollow central portion (2) so as to underlie the said body portion (4) of the or each component, and two opposed inwardly projecting portions (9,10) of the container arranged to extend along the opposite sides of the said component(s) and to engage the latter upon upward or lateral displacement thereof.

3. A container according to claim 1 or 2, wherein said conductive portions (8,9,10) are made conductive by carbon particles incorporated in the material of the container.

4. A container according to any preceding claim, further comprising a pair of end plugs for sealing the ends of said container.

5. A container according to any preceding claim, wherein said conductive portions (8,9,10) are electrically interconnected at at least one end of the container.

6. A container according to any preceding claim, wherein the said tubular member (1) is provided with upstanding conducting ribs (13,14) on the external surface thereof, arranged so that when two such containers are juxtaposed side by side the non-conductive portions of the containers cannot contact each other.

7. A container according to claim 6, wherein said conducting ribs (13,14) extend lengthwise of the container along the outwardly projecting corners of said tubular member (1)

8. A package comprising a container as claimed in any preceding claim which loosely houses one or more electrical components having a body portion (4) and two rows of terminals (5) extending from opposed sides of said body portion (4).

## Revendications

1. Un boîtier pour loger sans bloquer au moins un composant électrique ayant une partie de corps (4) et deux rangées de bornes (5) s'étendant de chaque côté opposé de ladite partie de corps (4), ledit boîtier comprenant un élément tubulaire allongé (1) présentant une section transversale fermée en forme de U inversé, la dite section transversale comprenant une partie centrale creuse (2) pour recevoir la partie dite corps (4) du ou de chaque composant, et deux parties de flanc creuses (3), une sur chaque côté de la dite partie centrale (2), pour recevoir les dites rangées de bornes (5), le boîtier étant en partie constitué de matière électriquement conductrice et en partie de matière transparente, caractérisé par le fait que le dit élément tubulaire (1) comprend plusieurs parties espacées conductrices d'électricité (8,9,10) qui peuvent entrer en contact avec un dit composant quand il est situé à l'intérieur, le reste de l'élément tubulaire (1) ne pouvant entrer en contact avec un dit composant quand celui ci est placé à l'intérieur et étant essentiellement transparent, les dites parties conductrices (8,9,10) étant interconnectées électriquement.

2. Boîtier selon la revendication 1 dans lequel les dites parties conductrices (8,9,10) s'étendent le long du boîtier et comprennent la paroi de base (8) de la dite partie centrale creuse (2) de manière à soutenir la dite partie de corps (4) du ou de chaque composant, et deux parties opposées saillantes intérieurement (9,10) de l'étui disposées de manière à s'étendre le long des côtés opposés du (ou des) dit(s) composant(s) et à venir en contact avec ce(s) dernier(s) lors d'un déplacement vers le haut ou latéral.

3. Boîtier selon la revendication 1 ou 2, dans lequel les dites parties conductrices (8,9,10) sont rendues conductrices par des particules de carbone incorporées dans la matière du boîtier.

4. Boîtier selon l'une quelconque des revendications précédentes, comprenant de plus un couple de bouchons d'extrémité pour sceller les extrémités du dit boîtier.

5. Boîtier selon l'une quelconque des revendications précédentes, dans lequel les dites parties conductrices (8,9,10) sont électriquement interconnectées à au moins une extrémité du boîtier.

6. Boîtier selon l'une quelconque des revendications précédentes, dans lequel le dit élément tubulaire (1) est muni de nervures saillantes conductrices (13,14) sur la surface externe, disposées de telle sorte que quand deux tels boîtiers sont juxtaposés côte à côte, les parties non conductrices des boîtiers ne peuvent pas entrer en contact l'une avec l'autre.

7. Boîtier selon la revendication 6, dans lequel les dites nervures conductrices (13,14) s'étendent en longueur dans le boîtier le long des coins saillants extérieurs du dit élément tubulaire (1).

8. Un ensemble comprenant un boîtier selon l'une quelconque des revendications précédentes, qui loge sans serrer un ou plusieurs composants ayant une partie de corps (4) et deux rangées de bornes (5) s'étendant des deux côtés opposés de la dite partie de corps (4).

## Patentansprüche

1. Behälter zur losen Aufnahme von zumindest einer elektrischen Komponente, welche einen Rumpfteil (4) und zwei Reihen von Anschlüssen (5) umfaßt, die sich von gegenüberliegenden Seiten des Rumpfteils (4) erstrecken, wobei der Behälter einen länglichen Hohlkörper (1) mit geschlossenem, im wesentlichen umgekehrten U-förmigen Querschnitt umfaßt und dieser Querschnitt einen hohlen Mittelteil (2) zur Aufnahme des Rumpfteils (4) der Komponente(n) beinhaltet und zwei hohle Seitenteile (3), jeweils einen an jeder Seite des Mittelteils (2) zur Aufnahme der Reihen von Anschlüssen (5), wobei der Behälter teilweise aus elektrisch leitendem Material und teilweise aus durchsichtigem Material besteht, dadurch gekennzeichnet, daß der Hohlkörper (1) eine Vielzahl von elektrisch leitenden Teilen (8,9,10) mit Abstand zueinander umfaßt, welche mit der Komponente in Berührung kommen kann, wenn diese darin enthalten ist, wobei der Rest des Hohlkörpers nicht mit einer dieser Komponenten in Berührung kommen kann, wenn diese darin enthalten sind, und im wesentlichen durchsichtig ist, wobei die leitenden Teile (8,9,10) elektrisch miteinander verbunden sind.

2. Behälter nach Anspruch 1, bei welchem sich die leitenden Teile (8,9,10) in Längsrichtung des Behälters erstrecken und die Bodenwand (8) des hohlen Mittelteils (2) umfassen, sodaß sie unter dem Rumpf (4) der oder jeder Komponente liegen, und zwei einander gegenüberliegende, nach innen vorspringende Teile (9,10) des Behälters, die derart angeordnet sind, daß sie sich entlang der gegenüberliegenden Seiten der Komponente(n) erstrecken und mit letzterer bei einer Verschiebung nach oben oder zur Seite in Berührung kommen.

3. Behälter nach Anspruch 1 oder 2, bei welchem die leitenden Teile (8,9,10) durch Einschluß von Kohlenstoffteilchen in dem Material, aus welchem der Behälter besteht, gebildet sind.

4. Behälter nach einem der vorhergehenden Ansprüche, der weiters ein Paar Endstöpsel zum Verschluß des Behälters umfaßt.

5. Behälter nach einem der vorhergehenden Ansprüche, bei welchem die leitenden Teile (8,9,10) an zumindest einem Ende des Behälters elektrisch verbunden sind.

6. Behälter nach einem der vorhergehenden Ansprüche, bei welchem der Hohlkörper (1) mit aufrechten leitenden Rippen (13,14) an der Außenfläche versehen ist, die derart angeordnet sind, daß, wenn zwei derartige Behälter Seite an Seite zu liegen kommen, die nichtleitenden Teile der Behälter nicht miteinander in Berührung kommen können.

7. Behälter nach Anspruch 6, bei welchem die leitenden Rippen (13,14) sich in Längsrichtung des Behälters entlang der nach außen vorstehenden Kanten des Hohlkörpers (1) erstrecken.

8. Verpackung, welche einen Behälter nach einem der vorhergehenden Ansprüche umfaßt, worin eine oder mehrere elektrische Komponente(n) mit einem Rumpfteil (4) und zwei Reihen von Anschlüssen (5), die sich von gegenüberliegenden Seiten des Rumpfteils (4) erstrecken, lose enthalten sind.

*FIG.1.*

*FIG.2.*

FIG.3.

9

12

FIG.4.

(a)

(b)

(c)

(d)

FIG.5.

FIG.6.